# FASCICULE DE BREVET EUROPEEN

(11) **EP 1 844 179 B1**
(45) Date de publication et mention de la délivrance du brevet: **06.11.2013**
(21) Numéro de dépôt: 06709422.7
(22) Date de dépôt: 23.01.2006
(51) Int. Cl.: C23C 16/455, C23C 16/04, C23C 16/26

(54) **PROCEDE D'INFILTRATION CHIMIQUE EN PHASE GAZEUSE POUR LA DENSIFICATION DE SUBSTRATS POREUX PAR DU CARBONE PYROLYTIQUE**
VERDICHTUNG VON PORÖSEN SUBSTRATEN MIT KOHLENSTOFF MITTELS CHEMISCHEN GASPHASENINFILTRATION
METHOD FOR CHEMICAL INFILTRATION IN THE GAS PHASE FOR THE DENSIFICATION OF POROUS SUBSTRATES WITH PYROLYTIC CARBON

(30) Priorité: 24.01.2005 FR 0500696
(43) Date de publication de la demande: 17.10.2007
(73) Titulaire: HERAKLES, 33185 Le Haillan (FR)
(72) Inventeur: THEBAULT, Jacques, F-33200 Bordeaux (FR); BERTRAND, Sébastien, F-33480 Moulis en Medoc (FR); ROBIN-BROSSE, Christian, F-33185 Le Haillan (FR); BERNARD, Bruno, F-33600 Pessac (FR); DOMBLIDES, Jean-Luc, F-33520 Bruges (FR)
(74) Mandataire: Joly, Jean-Jacques
(86) Numéro de dépôt international: PCT/FR2006/050037
(87) Numéro de publication internationale: WO 2006/077353

(56) Documents cités:
- FR-A- 2 834 052
- US-B1- 6 197 374

## Description

### Arrière plan et objet de l'invention

L'invention concerne la densification de substrats poreux par du carbone pyrolytique, ou pyrocarbone (PyC), obtenu par infiltration chimique en phase gazeuse (ou « CVI » pour « Chemical Vapor Infiltration »).

La densification de substrats poreux par PyC-CVI est bien connue. Dans un procédé couramment utilisé, les substrats à densifier sont chargés dans un four et une phase gazeuse réactionnelle, contenant au moins un gaz réactif précurseur de PyC et un gaz vecteur, est admise en entrée du four. Un gaz effluent contenant des constituants résiduels de la phase gazeuse réactionnelle et des sous-produits de réaction, est évacué en sortie du four. Les conditions opératoires, notamment température et pression dans le four, taux de gaz réactif précurseur dans la phase gazeuse, temps de séjour de la phase gazeuse dans le four, sont choisies pour former le dépôt PyC désiré au sein de la porosité des substrats.

Le gaz réactif précurseur, comprend au moins un hydrocarbure de type CₓH_{y}, où x et y sont des entiers naturels et x ≥ 2, par exemple du propane C₃H₈ ou du butane C₄H₁₀, ou encore du propylène C₃H₆. Il a pour fonction d'être le principal contributeur à la réaction de dépôt de PyC et est parfois qualifié de gaz dopant.

Le gaz vecteur a une fonction de dilution favorisant la diffusion de la phase gazeuse réactionnelle au coeur de la porosité des substrats. Il peut être constitué par un gaz neutre, tel que l'azote N₂, l'hélium He, l'argon Ar, ou encore du méthane CH₄. Le méthane, peu réactif, constitue en effet plus un gaz vecteur qu'un gaz précurseur de PyC.

Il est connu en outre du document US 5 789 026 d'ajouter du gaz hydrogène H₂ dans la phase gazeuse réactionnelle afin de moduler la cinétique de dépôt, H₂ ayant une fonction de ralentisseur dans une certaine plage de températures.

Cette fonction de H₂ dans un processus de densification par PyC-CVI est décrite également dans le document US 6 197 374 qui préconise l'utilisation d'une phase gazeuse formée de méthane CH₄ et de H₂, l'utilisation de pressions relativement élevées au regard des pressions habituelles et l'absence de gaz vecteur ou gaz de dilution. Un recyclage d'un flux gazeux extrait du gaz effluent est envisagé, mais l'élimination des composés hydrocarbures plus lourds que le méthane est réalisée. Le procédé décrit paraît être de type expérimental plutôt qu'industriel.

La possibilité de récupérer des constituants d'un gaz effluent dans un processus de densification par PyC-CVI est mentionnée dans le document US 5 348 774, pour un recyclage ou la production d'énergie, mais sans autre détail sur la mise en oeuvre possible du recyclage.

Les procédés connus et exploités de type PyC-CVI sont coûteux en termes de consommation de gaz constituants de la phase gazeuse réactionnelle et d'énergie.

Il est donc souhaitable de disposer d'un procédé CVI permettant une réduction sensible des coûts de densification de substrats poreux par du PyC.

### Résumé de l'invention

Ce but est atteint grâce à un procédé d'infiltration chimique en phase gazeuse pour la densification de substrats poreux par du carbone pyrolytique, tel que défini par la revendication 1.

Le procédé selon l'invention est ainsi remarquable en ce qu'une partie au moins de gaz précurseur de carbone pyrolytique contenu dans la phase gazeuse réactionnelle provient du flux gazeux recyclé.

Le gaz précurseur extrait du gaz effluent peut être un reliquat de celui présent dans la phase gazeuse réactionnelle admise dans le four. Il peut comporter aussi des produits de réaction engendrés dans le four.

Avantageusement alors, on mesure les quantités respectives de plusieurs gaz hydrocarbures contenus dans le flux gazeux extrait du gaz effluent et l'on détermine un taux équivalent en gaz précurseur de carbone pyrolytique par pondération des quantités mesurées en fonction du nombre x d'atomes de carbone dans lesdits gaz hydrocarbures, x étant tel que 1<x<6.

Il est en outre particulièrement avantageux que le gaz vecteur contenu dans la phase gazeuse réactionnelle admise dans le four provienne, pour une partie, du flux gazeux recyclé. Habituellement, le gaz vecteur est, en volume, un constituant principal et souvent majoritaire de la phase gazeuse réactionnelle et se retrouve en quantité importante dans le gaz effluent. Une partie importante du gaz vecteur dans la phase gazeuse réactionnelle peut donc provenir du recyclage, et une économie substantielle peut être réalisée quant à la consommation de gaz vecteur fourni par la source extérieure.

Le gaz vecteur peut être constitué au moins partiellement par du méthane. Le gaz vecteur peut aussi être constitué au moins partiellement par un gaz neutre par exemple choisi parmi l'azote, l'argon, l'hélium ou un mélange de deux ou plus de ceux-ci.

On peut en outre séparer de l'hydrogène contenu dans le flux gazeux extrait du gaz effluent et commander le débit d'hydrogène ainsi séparé qui est recyclé dans la phase gazeuse réactionnelle de manière à obtenir un taux désiré d'hydrogène dans la phase gazeuse réactionnelle admise en entrée du four.

En variante,
- on mesure les quantités de gaz réactif précurseur de carbone pyrolytique, de gaz vecteur, et d'hydrogène contenues dans le flux gazeux extrait du gaz effluent, et
- en fonction des quantités mesurées, on commande le débit dudit flux gazeux qui est recyclé dans la phase gazeuse réactionnelle, le débit du gaz réactif provenant d'une source externe de gaz réactif précurseur de carbone pyrolytique et injecté dans la phase gazeuse réactionnelle, et le débit de gaz vecteur provenant d'une source externe de gaz vecteur et injecté dans la phase gazeuse réactionnelle,
- de manière à obtenir des taux désirés de gaz réactif précurseur de carbone pyrolytique, de gaz vecteur et d'hydrogène dans la phase gazeuse réactionnelle admise en entrée du four.

Au moins dans une phase initiale du procédé, on peut alors commander en outre un débit d'hydrogène provenant d'une source externe d'hydrogène et injecté dans la phase gazeuse réactionnelle.

Il est connu que la cinétique de dépôt du carbone pyrolytique peut être contrôlée au moins en partie par addition d'hydrogène à la phase gazeuse réactionnelle. L'ajout d'hydrogène à la phase gazeuse réactionnelle provoque, en effet, un ralentissement de la cinétique de dépôt du PyC. Cela peut être exploité pour réduire le gradient de densification de substrats, notamment de substrats de forte épaisseur. En effet, le ralentissement de la cinétique de dépôt augmente les chances d'une phase gazeuse encore riche en précurseur de PyC d'atteindre le coeur des substrats.

Une production d'hydrogène a lieu dans le four, par décomposition du gaz précurseur de carbone pyrolytique.

L'effet éventuellement recherché de la présence d'hydrogène dans la phase gazeuse réactionnelle peut avantageusement être obtenu par recyclage de l'hydrogène présent dans le gaz effluent. Une source externe d'hydrogène peut alors ne pas être nécessaire, sinon éventuellement dans une phase initiale du procédé.

Le gaz effluent extrait du four est avantageusement traité avant extraction du flux gazeux en vue du recyclage, pour éliminer des hydrocarbures lourds comprenant notamment des hydrocarbures aromatiques polycycliques. Le traitement peut être réalisé au moins en partie par lavage par injection d'huile aromatique dans un courant de gaz effluent, comme décrit dans le document US 2003/0101869.

L'élimination d'hydrocarbures lourds, en particulier des goudrons, peut aussi être au moins partiellement réalisée par condensation.

Le traitement du gaz effluent peut aussi comporter l'élimination d'hydrocarbures benzéniques, ce qui peut aussi être réalisé par condensation comme décrit également dans le document US 2003/0101869.

Le procédé peut être mis en oeuvre au moyen d'une installation de PyC-CVI comportant un four, un circuit d'alimentation du four en phase gazeuse réactionnelle relié à une entrée d'admission dans le four, une sortie de gaz effluent hors du four, un circuit de traitement et d'évacuation du gaz effluent comprenant un dispositif d'élimination d'hydrocarbures lourds contenus dans le gaz effluent, et un circuit de recyclage connecté d'une part au circuit de traitement et d'évacuation du gaz effluent en aval du dispositif d'élimination d'hydrocarbures lourds et d'autre part au circuit d'alimentation du four en phase gazeuse réactionnelle pour recycler dans celle-ci au moins une fraction du gaz effluent.

Avantageusement, l'installation comporte des moyens d'analyse de la teneur du gaz effluent en constituants susceptibles d'être recyclés. L'installation peut alors en outre comporter une unité de commande reliée aux moyens d'analyse et à plusieurs vannes des circuits d'alimentation, d'évacuation et de recyclage afin de commander la ou les fractions de gaz effluent recyclés en fonction d'informations reçues des moyens d'analyse et d'une composition désirée de la phase gazeuse réactionnelle admise dans le four.

### Brève description des dessins

L'invention sera mieux comprise à la lecture de la description faite ci-après, à titre indicatif mais non limitatif, en référence aux dessins annexés, sur lesquels :
- les figures 1 et 2 sont des vues très schématiques de principe, respectivement complète et partielle, d'installations permettant la mise en oeuvre d'un procédé conforme à l'invention ; et
- les figures 3 et 4 illustrent à l'échelle agrandie des détails du séparateur de l'installation de la figure 2, la figure 3 étant une vue partielle en coupe suivant le plan III-III de la figure 2.

### Description détaillée de modes de réalisation de l'invention

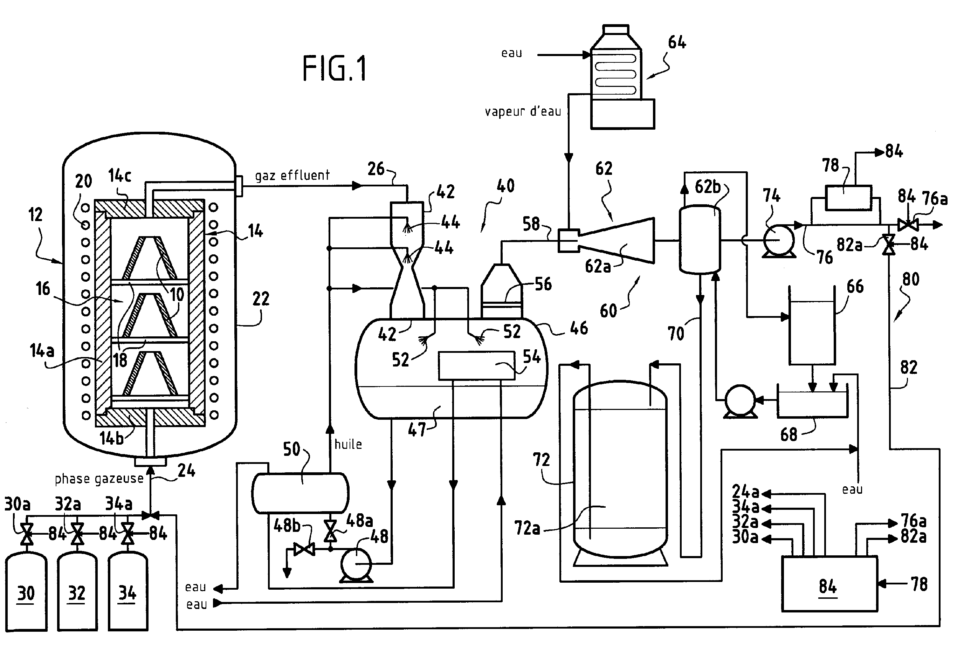

L'installation de la figure 1 comprend un four 12 dans lequel un processus de densification de substrats poreux par une matrice PyC obtenue par CVI est réalisé. Le four 12 comprend un suscepteur 14 en graphite de forme générale cylindrique d'axe vertical avec une paroi latérale 14a, un fond 14b et un couvercle 14c. Des substrats 10 à densifier sont disposés dans la chambre 16 définie par le suscepteur 14. Les substrats 10 sont par exemple constitués par des préformes fibreuses ayant une forme voisine d'une pièce en matériau composite à matrice PyC à réaliser. Les substrats reposent par exemple sur des plateaux de chargement 18 dans la chambre 16.

Le chauffage du four est produit par exemple par couplage inductif entre un inducteur 20 et la paroi latérale 14a du suscepteur. L'inducteur 20 entoure la paroi 14a en étant séparée de celle-ci par un isolant (non représenté). L'ensemble formé par le suscepteur 14 et l'inducteur 20 est logé dans une enveloppe métallique 22.

Une phase gazeuse réactionnelle est admise dans le four par une conduite d'alimentation 24 et parvient dans la chambre 16 à travers le fond de celle-ci. Un préchauffage du gaz immédiatement après son entrée dans la chambre 16 pourra être réalisé en obligeant le gaz à traverser une zone de préchauffage formée par exemple par des plateaux perforés superposés disposés au-dessus du fond 14b. La phase gazeuse peut ainsi être portée à une température très proche de celle à laquelle le processus PyC/CVI est réalisé, celle-ci étant généralement d'environ 1000°C.

Le gaz effluent est extrait à travers le couvercle 14c et est évacué par une conduite d'extraction 26 reliée à une source de vide constituée par un dispositif de pompage 60 permettant de maintenir dans la chambre 16 la pression réduite requise.

La phase gazeuse admise dans le four comprend notamment du gaz précurseur de carbone et du gaz vecteur fournis par des sources externes 30, 32. Le gaz réactif précurseur de carbone est constitué par un ou plusieurs hydrocarbures gazeux CₓH_{y} dans lesquels x et y sont des nombres entiers et x est tel que 1 < x < 6. On utilise par exemple une source 30 de propane C₃H₈. Le gaz vecteur est de préférence choisi parmi l'azote, l'argon, l'hélium et le méthane. La source 32 est par exemple une source d'azote N₂.

Les sources 30 et 32 sont reliées à la conduite d'alimentation 24 par des conduites respectives sur lesquelles sont montées des vannes 30a, 32a permettant de régler les débits de gaz précurseur et de gaz vecteur extraits des sources 30 et 32. Une vanne supplémentaire peut être montée sur la conduite 24 immédiatement en amont de l'entrée du four 12.

Une installation telle que décrite ci-avant est bien connue de l'homme de l'art pour la mise en oeuvre de processus de densification de type PyC/CVI.

Le gaz effluent contient des produits de réaction sous forme d'hydrocarbures plus ou moins lourds, un résidu du gaz précurseur de PyC, du gaz vecteur, et de l'hydrogène H₂ provenant de la décomposition du gaz précurseur.

Après son extraction du four, le gaz effluent est traité afin d'en séparer au moins la plus grande partie d'hydrocarbures lourds qu'il contient. Des processus tels que lavage à l'huile ou condensation permettent l'élimination de tels hydrocarbures lourds, tels que des goudrons, hydrocarbures aromatique polycycliques (HAP) et hydrocarbures benzéniques.

On pourra avantageusement utiliser, pour l'élimination d'HAP, un dispositif de traitement 40 tel que celui décrit dans le document FR 2 832 936.

Le gaz effluent extrait du four à une température encore élevée est admis à la partie supérieure d'une colonne 42 à Venturi. Une huile est injectée dans cette partie supérieure de la colonne 42 par un ou plusieurs injecteurs 44. On utilise une huile capable de dissoudre les HAP, notamment une huile minérale de type aromatique ayant de préférence une tension de vapeur faible, inférieure à 100 Pa à 0°C, pour ne pas se vaporiser à la pression réduite du gaz effluent, telle qu'une huile à base de xylènes.

L'huile est prélevée dans un réservoir 46 au moyen d'une pompe 48 et est refroidie par passage dans un échangeur de chaleur 50 avant d'alimenter les injecteurs 44. La colonne 42 s'ouvre à sa partie inférieure dans le réservoir 46 de sorte que l'huile chargée de HAP dissous est recueillie dans le réservoir et circule en continu.

Le gaz effluent traverse le réservoir 46, à sa partie supérieure. Des injecteurs d'huile supplémentaires 52 peuvent être prévus dans le réservoir 46, sur le trajet du gaz, ainsi qu'un condenseur 54. L'échangeur 50 et le condenseur 54 sont parcourus par des canalisations d'eau de refroidissement. Des vannes 48a, 48b en aval de la pompe 48 permettent de diriger l'huile sélectivement vers les injecteurs 44, 52 ou vers une conduite de vidange.

Un dévésiculeur 56, par exemple de type à chicanes, contribue à « casser » un brouillard présent en sortie du réservoir 46 pour séparer les goulettes et provoquer leur coalescence afin de les recueillir dans le bain d'huile 47 occupant la partie inférieure du réservoir 46.

Le piégeage par le dispositif de lavage à l'huile 40 permet d'éliminer un maximum de goudrons tels que les HAP. Seuls des hydrocarbures aromatiques plus légers (benzènes, hydrocarbures monocycliques) peuvent subsister dans le gaz effluent lavé, mais ils ne présentent pas de risque d'encrassement de conduites en raison de leur tension de vapeur plus élevée.

Le dispositif de pompage 60, relié à la sortie du dévésiculeur 56 par une conduite 58, comprend un éjecteur-condenseur 62, ou plusieurs éjecteurs-condenseurs semblables disposés en série (un seul étant montré sur la figure).

L'éjecteur-condenseur 62 comprend une partie éjecteur 62a alimenté en vapeur d'eau par une chaudière 64, et une partie condenseur 62b située en aval de l'éjecteur. Le condenseur 62b est par exemple un condenseur indirect, le gaz issu de l'éjecteur étant amené au contact de conduites parcourues par un fluide de refroidissement, par exemple de l'eau froide.

Après passage dans le condenseur 62b, l'eau est amenée à une tour de refroidissement 66 d'où elle peut être recueillie dans un bac 68 dans lequel de l'eau de complément peut être ajoutée pour réaliser une circulation continue par une pompe insérée sur une conduite reliant le bac 68 au condenseur 62b.

Le condensat recueilli sur une conduite 70 en sortie du condenseur contient des hydrocarbures benzéniques (BTX) tels que benzène, toluène, xylène et un éventuel reliquat de HAP dissous dans l'eau provenant de la condensation de la vapeur de l'éjecteur 62a. Le condensat est traité par adsorption par un lit fixe 72a de charbon actif contenu dans une colonne d'adsorption 72. La conduite 70 est raccordée au sommet de la colonne 72 et l'eau épurée recueillie au bas de la colonne peut être acheminée vers le bac 68.

En sortie du condenseur 62b, le gaz effluent passe dans une pompe 74. On pourra utiliser une pompe à anneau d'eau refroidie par échangeur de manière que le gaz extrait de l'installation de traitement soit pratiquement à température ambiante.

Un dispositif d'analyse 78 est monté en dérivation sur la conduite 76 de sortie de la pompe 74 pour analyser la composition du gaz extrait par la pompe 74, notamment les quantités respectives de gaz précurseur de PyC, de gaz vecteur et d'hydrogène H₂. Le gaz précurseur contenu dans le gaz effluent comprend un résidu du gaz précurseur réactif admis en entrée du four 12 et des produits de réaction sous forme CₓH_{y}, x et y étant des nombres entiers. Le dispositif d'analyse 78 est par exemple un spectromètre de masse, ou un chromatographe en phase gazeuse, ou les deux, ou encore tout autre moyen d'analyse connu.

Un circuit de recyclage 80 permet de recycler dans la phase gazeuse réactionnelle admise dans le four une fraction du gaz effluent débarrassé d'hydrocarbures lourds. A cet effet, une conduite de recyclage 82 est branchée en dérivation de la conduite 76 en aval du dispositif d'analyse 78. Des vannes 82a, 76a permettent de commander le débit de gaz recyclé admis dans la conduite 82 et le débit de gaz évacué par la conduite 76 vers une torchère et/ou un dispositif d'alimentation de la chaudière 64 en gaz combustible.

La fraction de gaz effluent extraite par la conduite 82 est amenée à la conduite 24 d'alimentation du four en phase gazeuse.

La phase gazeuse contient alors du gaz réactif précurseur de PyC, du gaz vecteur et de l'hydrogène H₂.

Comme indiqué plus haut, la présence d'H₂ a un effet ralentisseur de la cinétique de dépôt du PyC et contribue à réduire le gradient de densification des substrats poreux entre le coeur et les parties externes de ceux-ci. Après une première phase de densification à cinétique de dépôt ralentie, cette cinétique peut être augmentée par élévation de la température et/ou de la pression dans le four et/ou du taux de dopage (la proportion de gaz précurseur). Une même durée globale de densification, voire même une durée inférieure peut alors être suffisante pour atteindre un degré de densification sensiblement égal à celui obtenu sans ajout de H₂, mais avec un gradient de densification moindre. On peut aussi faire varier le débit de H₂ pendant le déroulement du processus CVI.

La quantité désirée d'hydrogène dans la phase gazeuse réactionnelle est ici apportée par le recyclage d'une fraction du gaz effluent. Toutefois, au moins au démarrage du processus CVI, un apport de H₂ externe peut être nécessaire. On prévoit alors une source de H₂ externe 34 reliée à la conduite d'alimentation 24 par une conduite sur laquelle est montée une vanne 34a.

Pour évaluer la teneur en gaz précurseur de carbone contenue dans la fraction de gaz effluent dérivée par la conduite de recyclage 82, on prend en compte les quantités d'hydrocarbures présents CₓH_{y} mesurées par le dispositif d'analyse 78 pour lesquels 1 < x < 6. Les quantités mesurées pour chaque hydrocarbure CₓH_{y} sont pondérées par un coefficient multiplicateur x. On peut alors déterminer une teneur en gaz précurseur « équivalente » à une teneur en gaz précurseur fourni par la source externe, ici C₃H₈. Les informations fournies par le dispositif d'analyse 78 sont transmises à un automate, ou unité de commande 84 qui, notamment, évalue la teneur, dans le gaz effluent, en gaz réactif précurseur équivalent à C₃H₈.

Pour une composition et un débit désirés de phase gazeuse réactionnelle admise dans le four, permettant notamment d'obtenir un PyC de microstructure particulière, le dispositif de commande 84 commande les vannes 30a, 32a, 34a, 76a et 82a pour obtenir cette composition et ce débit voulus en fonction des informations fournies par le dispositif d'analyse 78. Bien entendu, la composition et le débit de phase gazeuse réactionnelle pourront varier au cours du déroulement du processus CVI.

On pourra par exemple régler d'abord les vannes 76a, 82a et 34a pour avoir la quantité voulue de H₂, étant noté que l'on privilégiera à cette fin l'utilisation du recyclage, la source 34 n'étant utilisée que si la quantité de H₂ dans le gaz effluent est insuffisante, en particulier au début du processus. La vanne 82a étant réglée, on connaît alors les quantités de gaz réactif précurseur et de gaz vecteur dans le gaz recyclé. Ces quantités étant nécessairement inférieures à celles présentes en entrée du four, puisqu'il y a consommation de gaz précurseur et déperdition inévitable de gaz vecteur, les vannes 30a et 32a sont alors commandées pour apporter les compléments nécessaires.

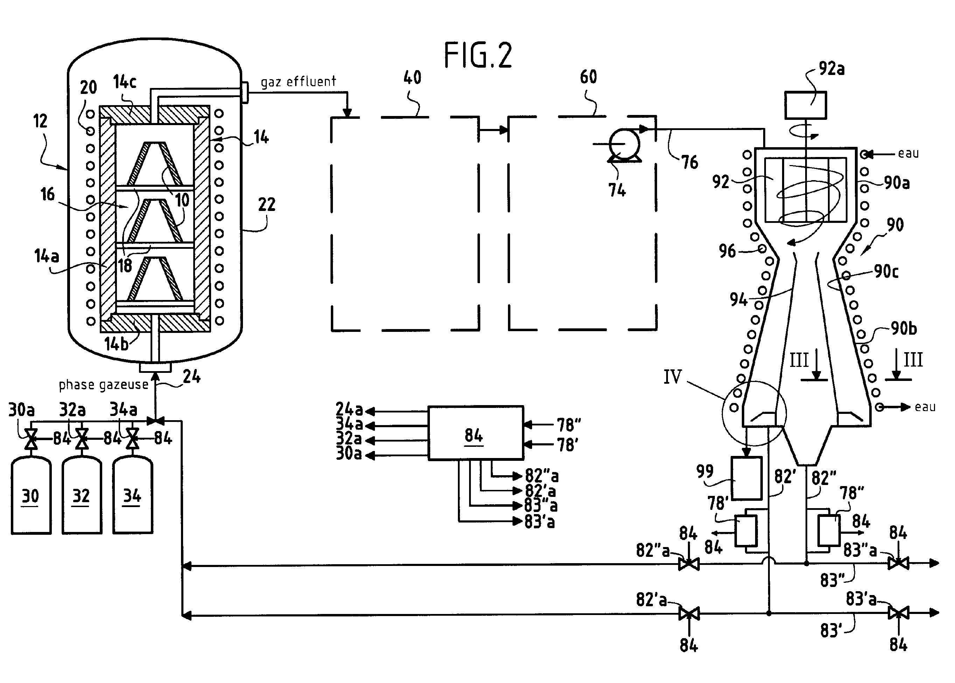

La figure 2 illustre une variante de réalisation selon laquelle un traitement du gaz effluent est effectué pour séparer H₂ de celui-ci. Les éléments communs aux modes de réalisation des figures 1 et 2 portent les mêmes numéros de références. Les dispositifs de lavage 40 et de pompage 60 de l'installation de la figure 2 sont identiques à ceux de la figure 1 et ne sont pas représentés en détail.

Un séparateur 90 est monté sur la conduite 76 en sortie de la pompe 74. Le séparateur 90 est de type connu à cage tournante permettant d'effectuer une séparation entre espèces gazeuses de masses moléculaires différentes en utilisant la force centrifuge. Le séparateur 90 a une forme générale de colonne à Venturi avec une partie supérieure cylindrique 90a à section sensiblement circulaire raccordée par un col de section réduite à une partie inférieure tronconique 90b s'évasant vers le bas. La fraction recyclée est admise par la conduite 76 à la partie supérieure du séparateur dans laquelle est logée une cage tournante 92 entraînée en rotation autour de l'axe vertical du séparateur par un moteur 92a.

Le gaz admis dans le séparateur est ainsi entraîné en rotation. Les composés gazeux les plus lourds se rassemblent au voisinage de la paroi interne 90c du séparateur tandis que les plus légers restent dans la partie centrale. Une paroi fixe tronconique 94 peut être disposés dans la partie inférieure du séparateur pour éviter un mélange entre les constituants séparés par la force centrifuge.

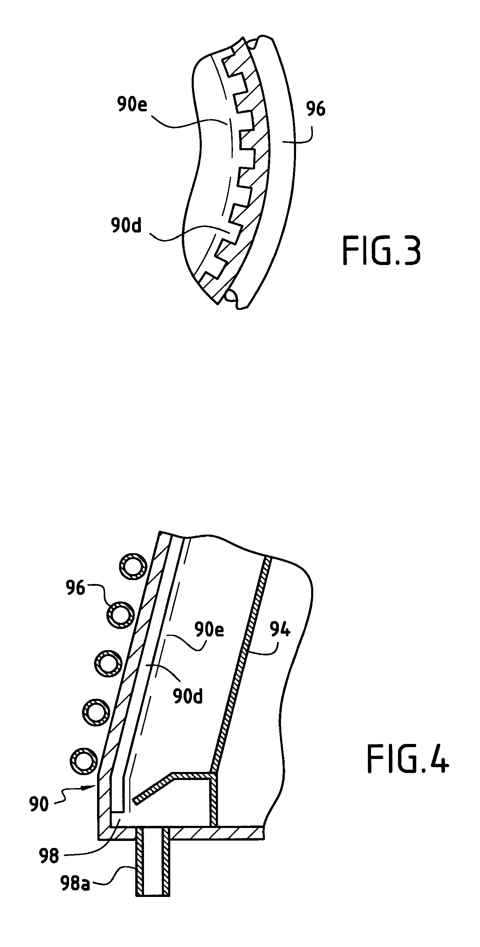

La paroi du séparateur est refroidie par circulation d'eau de refroidissement dans une conduite 96 hélicoïdale en contact avec la face externe de cette paroi. Les espèces les plus lourdes parvenant au contact de la paroi du séparateur peuvent ainsi être condensées. Du côté interne, la paroi du séparateur peut présenter des rainures 90d éventuellement en spirales qui s'étendent du haut vers le bas, et être munie d'une grille de captation capillaire 90e, comme montré sur la figure 3. Ainsi, les espèces condensées captées par la grille 90e peuvent s'écouler le long des rainures 90d jusqu'au bas du séparateur où elles peuvent être recueillies dans une rigole annulaire 98 (figure 4), d'où elles peuvent être prélevées par une conduite de vidange 98a, pour être recueillies dans un bac 99.

Des hydrocarbures légers, comprenant des gaz réactifs précurseurs de PyC sont recueillis à la base du séparateur 90, du côté extérieur de la paroi 94, par une conduite 82'. Une conduite d'évacuation 83' est connectée en dérivation sur la conduite 82' pour évacuer la fraction non recyclée du flux recueilli par la conduite 82' vers une torchère et/ou un dispositif d'alimentation en gaz combustible pour la chaudière produisant la vapeur pour l'éjecteur-condenseur du dispositif de pompage 60.

Une phase gazeuse contenant essentiellement du gaz hydrogène H₂ est recueillie à la base du séparateur 90, à la partie centrale de celui-ci, du côté interne de la paroi 94, par une conduite 82". Une conduite d'évacuation 83" est connectée en dérivation sur la conduite 82" pour évacuer la fraction non recyclée du flux recueilli par la conduite 82", par exemple vers une torchère.

Du gaz vecteur peut être présent dans la conduite 82' et/ou dans la conduite 82".

Des vannes 82'a, 82"a, 83'a, 83"a sont montées sur les conduites 82', 82", 83' et 83" et sont commandées par l'unité de commande 84.

Des dispositifs d'analyse 78', 78" sont montés en dérivation sur les conduites 82', 82" immédiatement en sortie du séparateur 90 pour permettre de mesurer les quantités de gaz réactif précurseur de PyC et de gaz vecteur circulant dans la conduite 82' et de gaz hydrogène H₂, et éventuellement de gaz vecteur circulant dans la conduite 82". Les dispositifs d'analyse 78' et 78" sont montés en amont des vannes 82'a et 82"a. Les informations recueillies par les dispositifs d'analyse 78', 78" sont transmises à l'unité de commande 84. Il n'est pas nécessaire de prévoir un dispositif d'analyse en dérivation de la conduite 76.

L'installation de la figure 2 permet de réaliser un processus PyC/CVI sans nécessairement introduire de gaz H₂ dans la phase gazeuse réactionnelle. Il suffit pour cela de ne pas utiliser de source externe de H₂ et de commander les vannes 82"a et 83"a pour évacuer la totalité du gaz prélevé dans la partie axiale centrale du séparateur 90. Dans ce cas, le dispositif de commande 84 est programmé pour alimenter le four 10 avec une phase gazeuse ayant un taux désiré de gaz réactif précurseur par rapport au gaz vecteur et un débit total désiré, et commande en conséquence les vannes 30a, 32a, 82a, 82'a et 83'a. On pourra alors privilégier le recyclage d'une quantité aussi élevée que possible de gaz précurseur et vecteur.

L'installation de la figure 2 permet à l'évidence aussi de réaliser un processus PyC/CVI avec une phase gazeuse réactionnelle contenant H₂. Les proportions respectives désirées de gaz réactif précurseur de PyC, gaz vecteur et H₂ sont obtenues, ainsi que le débit total de phase gazeuse, par commande de différentes vannes des circuits d'alimentation externe et de recyclage.

Le recyclage d'une fraction de gaz effluent est avantageusement réalisé après élimination d'hydrocarbures lourds tels que les HAP et, avantageusement aussi, les hydrocarbures benzéniques. L'élimination pourra être réalisée par des moyens autres que ceux décrits ci-dessus, par exemple en utilisant un ou plusieurs condenseurs en série avec refroidissement progressif du gaz effluent.

## Revendications

1. Procédé d'infiltration chimique en phase gazeuse pour la densification de substrats poreux par du carbone pyrolytique, comprenant les étapes de :
- chargement dans un four d'un ou plusieurs substrats poreux à densifier,
- admission en entrée du four d'une phase gazeuse réactionnelle contenant un gaz réactif précurseur de carbone pyrolytique comprenant au moins un hydrocarbure gazeux CₓH_{y} dans lequel x et y sont des nombres entiers et x est tel que 1 < x < 6, et un gaz vecteur comprenant au moins un gaz choisi parmi le méthane et des gaz neutres, et
- extraction en sortie du four de gaz effluent contenant des constituants résiduels de la phase gazeuse admise et des produits de réaction, dont de l'hydrogène, **caractérisé en ce que** :
- une fraction au moins d'un flux gazeux extrait du gaz effluent et contenant du gaz réactif précurseur de carbone pyrolytique est recyclée dans la phase gazeuse réactionnelle admise en entrée du four, de sorte qu'au moins une partie du gaz réactif précurseur de carbone pyrolytique contenu dans la phase gazeuse réactionnelle provient du flux gazeux recyclé,
- on mesure au moins les quantités de gaz précurseur de carbone pyrolytique et de gaz vecteur contenues dans le flux gazeux extrait du gaz effluent et,
- en fonction des quantités mesurées, on commande au moins le débit dudit flux gazeux qui est recyclé dans la phase gazeuse réactionnelle et qui contient du gaz réactif précurseur de carbone pyrolytique et du gaz vecteur, le débit de gaz précurseur provenant d'une source externe de gaz précurseur de carbone pyrolytique et injecté dans la phase gazeuse réactionnelle, et le débit de gaz vecteur provenant d'une source externe de gaz vecteur et injecté dans la phase gazeuse réactionnelle,
- de manière à obtenir un taux désiré de gaz précurseur de carbone pyrolytique dans la phase gazeuse réactionnelle admise en entrée du four.

2. Procédé selon la revendication 1, **caractérisé en ce que** l'on sépare de l'hydrogène contenu dans le flux gazeux extrait du gaz effluent, et on commande en outre le débit d'hydrogène ainsi séparé qui est recyclé dans la phase gazeuse réactionnelle de manière à obtenir un taux désiré d'hydrogène dans la phase gazeuse réactionnelle admise en entrée du four.

3. Procédé selon la revendication 1, **caractérisé en ce que** :
- on mesure les quantités de gaz précurseur de carbone pyrolytique, de gaz vecteur, et d'hydrogène contenues dans le flux gazeux extrait du gaz effluent, et
- en fonction des quantités mesurées, on commande le débit dudit flux gazeux qui est recyclé dans la phase gazeuse réactionnelle, le débit du gaz réactif provenant d'une source externe de gaz réactif précurseur de carbone pyrolytique et injecté dans la phase gazeuse réactionnelle, et le débit de gaz vecteur provenant d'une source externe de gaz vecteur et injecté dans la phase gazeuse réactionnelle,
- de manière à obtenir des taux désirés de gaz réactif précurseur de carbone pyrolytique, de gaz vecteur et d'hydrogène dans la phase gazeuse réactionnelle admise en entrée du four.

4. Procédé selon l'une quelconque des revendications 2 et 3, **caractérisé en ce que**, au moins dans une phase initiale du procédé, on commande en outre le débit d'hydrogène provenant d'une source externe d'hydrogène et injecté dans la phase gazeuse réactionnelle.

5. Procédé selon l'une quelconque des revendications 1 à 4, **caractérisé en ce que** l'on mesure les quantités respectives de plusieurs gaz hydrocarbures contenus dans le flux gazeux extrait du gaz effluent et l'on détermine un taux équivalent en gaz précurseur de carbone pyrolytique par pondération des quantités mesurées en fonction du nombre x d'atomes de carbone dans lesdits gaz hydrocarbures.

6. Procédé selon la revendication 5, **caractérisé en ce que** l'on prend en compte les gaz hydrocarbures CₓH_{y} pour lesquels 1 < x < 6.

7. Procédé selon l'une quelconque des revendications 1 à 6, **caractérisé en ce que** le gaz vecteur est constitué au moins partiellement par du méthane.

8. Procédé selon l'une quelconque des revendications 1 à 7, **caractérisé en ce que** le gaz vecteur est constitué au moins partiellement par un gaz neutre choisi parmi l'azote, l'argon, l'hélium, ou un mélange de deux ou plus de ceux-ci.

9. Procédé selon l'une quelconque des revendications 1 à 8, **caractérisé en ce que** le gaz effluent évacué du four est traité avant extraction du flux gazeux pour recyclage, afin d'éliminer des hydrocarbures lourds comprenant notamment des hydrocarbures aromatiques polycycliques.

10. Procédé selon la revendication 9, **caractérisé en ce que** l'élimination d'hydrocarbures aromatiques polycycliques est réalisée par lavage par injection d'huile aromatique dans un courant de gaz effluent.

11. Procédé selon la revendication 9, **caractérisé en ce que** l'élimination d'hydrocarbures lourds est réalisée au moins en partie par condensation.

12. Procédé selon l'une quelconque des revendications 9 à 11, **caractérisé en ce que** le traitement du gaz effluent comprend l'élimination d'hydrocarbures benzéniques.

## Patentansprüche

1. Verfahren zur chemischen Gasphaseninfiltration für die Verdichtung poröser Substrate durch pyrolytischen Kohlenstoff, umfassend die Schritte des:
- Ladens eines oder mehrerer zu verdichtender poröser Substrate in einen Ofen,
- Zuführens, am Eingang des Ofens, einer Reaktionsgasphase, die ein reaktives Vorläufergas von pyrolytischem Kohlenstoff, das wenigstens einen gasförmigen Kohlenwasserstoff CₓH_{y} umfasst, wobei x und y ganze Zahlen sind und x derart ist, dass 1 < x < 6 ist, sowie ein Trägergas enthält, das wenigstens ein Gas, das aus Methan und Neutralgasen ausgewählt ist, umfasst, und des
- Abziehens von ausströmendem Gas am Ausgang des Ofens, das Restbestandteile der zugeführten Gasphase sowie Reaktionsprodukte, darunter Wasserstoff enthält,
**dadurch gekennzeichnet, dass**:
- wenigstens ein Teil eines Gasstroms, der aus dem ausströmenden Gas entnommen ist und reaktives Vorläufergas von pyrolytischem Kohlenstoff enthält, in die am Eingang des Ofens zugeführte Reaktionsgasphase zurückgeführt wird, so dass wenigstens ein Teil des reaktiven Vorläufergases von pyrolytischem Kohlenstoff, das in der Reaktionsgasphase enthalten ist, aus dem zurückgeführten Gasstrom stammt,
- wenigstens die Mengen an Vorläufergas von pyrolytischem Kohlenstoff und an Trägergas, welche in dem aus dem ausströmenden Gas entnommenen Gasstrom enthalten sind, gemessen werden, und
- in Abhängigkeit der gemessenen Mengen wenigstens der Durchsatz des Gasstroms, der in die Reaktionsgasphase zurückgeführt wird und der reaktives Vorläufergas von pyrolytischem Kohlenstoff und Trägergas enthält, der Durchsatz von Vorläufergas, das aus einer externen Quelle von Vorläufergas von pyrolytischem Kohlenstoff stammt und in die Reaktionsgasphase eingeleitet wird, sowie der Durchsatz von Trägergas, das aus einer externen Trägergasquelle stammt und in die Reaktionsgasphase eingeleitet wird, gesteuert werden,
- um einen gewünschten Gehalt an Vorläufergas von pyrolytischem Kohlenstoff in der am Eingang des Ofens zugeführten Reaktionsgasphase zu erreichen.

2. Verfahren nach Anspruch 1, **dadurch gekennzeichnet, dass** Wasserstoff, der in dem aus dem ausströmenden Gas entnommenen Gasstrom enthalten ist, abgespalten wird und ferner der Durchsatz von auf diese Weise abgespaltenem Wasserstoff gesteuert wird, der in die Reaktionsgasphase zurückgeführt wird, um einen gewünschten Gehalt an Wasserstoff in der am Eingang des Ofens zugeführten Reaktionsgasphase zu erreichen.

3. Verfahren nach Anspruch 1, **dadurch gekennzeichnet, dass**:
- die Mengen an Vorläufergas von pyrolytischem Kohlenstoff, an Trägergas und an Wasserstoff, die in dem aus dem ausströmenden Gas entnommenen Gasstrom enthalten sind, gemessen werden, und
- in Abhängigkeit der gemessenen Mengen der Durchsatz des Gasstroms, der in die Reaktionsgasphase zurückgeführt wird, der Durchsatz des reaktiven Gases, das aus einer externen Quelle von reaktivem Vorläufergas von pyrolytischem Kohlenstoff stammt und in die Reaktionsgasphase eingeleitet wird, sowie der Durchsatz von Trägergas, das aus einer externen Trägergasquelle stammt und in die Reaktionsgasphase eingeleitet wird, gesteuert werden,
- um gewünschte Gehalte an reaktivem Vorläufergas von pyrolytischem Kohlenstoff, an Trägergas und an Wasserstoff in der am Eingang des Ofens zugeführten Reaktionsgasphase zu erreichen.

4. Verfahren nach einem der Ansprüche 2 und 3, **dadurch gekennzeichnet, dass** wenigstens in einer Anfangsphase des Verfahrens ferner der Durchsatz von Wasserstoff, der aus einer externen Wasserstoffquelle stammt und in die Reaktionsgasphase eingeleitet wird, gesteuert wird.

5. Verfahren nach einem der Ansprüche 1 bis 4, **dadurch gekennzeichnet, dass** die jeweiligen Mengen von mehreren Kohlenwasserstoffgasen, die in dem aus dem ausströmenden Gas entnommenen Gasstrom enthalten sind, gemessen werden und ein äquivalenter Gehalt an Vorläufergas von pyrolytischem Kohlenstoff durch Gewichten der gemessenen Mengen in Abhängigkeit der Anzahl x von Kohlenstoffatomen in den Kohlenwasserstoffgasen bestimmt wird.

6. Verfahren nach Anspruch 5, **dadurch gekennzeichnet, dass** die Kohlenwasserstoffgase CₓH_{y} berücksichtigt werden, bei denen 1 < x < 6.

7. Verfahren nach einem der Ansprüche 1 bis 6, **dadurch gekennzeichnet, dass** das Trägergas wenigstens teilweise von Methan gebildet ist.

8. Verfahren nach einem der Ansprüche 1 bis 7, **dadurch gekennzeichnet, dass** das Trägergas wenigstens teilweise von einem Neutralgas, welches aus Stickstoff, Argon, Helium ausgewählt ist, oder einer Mischung aus zwei oder mehr von diesen gebildet ist.

9. Verfahren nach einem der Ansprüche 1 bis 8, **dadurch gekennzeichnet, dass** das aus dem Ofen abgeführte ausströmende Gas vor Entnahme des Gasstroms für die Rückführung behandelt wird, um schwere Kohlenwasserstoffe, die insbesondere polyzyklische aromatische Kohlenwasserstoffe umfassen, zu entfernen.

10. Verfahren nach Anspruch 9, **dadurch gekennzeichnet, dass** das Entfernen von polyzyklischen aromatischen Kohlenwasserstoffen durch Waschen mittels Einspritzen von aromatischem Öl in einen Strom von ausströmendem Gas vollzogen wird.

11. Verfahren nach Anspruch 9, **dadurch gekennzeichnet, dass** das Entfernen von schweren Kohlenwasserstoffen wenigstens teilweise durch Kondensation vollzogen wird.

12. Verfahren nach einem der Ansprüche 9 bis 11, **dadurch gekennzeichnet, dass** die Behandlung des ausströmenden Gases das Entfernen von Benzolkohlenwasserstoffen umfasst.

## Claims

1. A chemical vapor infiltration method for densifying porous substrates with pyrolytic carbon, the method comprising the steps of:
· loading one or more porous substrates for densifying in an oven;
· admitting into the oven a reaction gas containing a pyrolytic carbon precursor reagent gas having at least one gaseous hydrocarbon CₓH_{y} in which x and y are natural integers and x is such that 1 < x < 6, together with a vector gas comprising at least one gas selected from methane and inert gases;
· extracting from the oven an effluent gas containing residual components of the admitted gas and reaction products, including hydrogen, **characterized by**:
· recycling at least a fraction of a gas stream extracted from the effluent gas and containing pyrolytic carbon precursor reagent gas into the reaction gas admitted into the oven, whereby at least a portion of the pyrolytic carbon precursor reagent gas contained in the reaction gas comes from the recycled gas stream,
· measuring at least the quantities of pyrolytic carbon precursor gas and of vector gas contained in the gas stream extracted from the effluent gas; and
· as a function of the measured quantities, controlling at least: the flow rate of said gas stream that is recycled in the reaction gas and that contains pyrolytic carbon precursor reagent gas and vector gas; the flow rate of precursor gas coming from an external source of pyrolytic carbon precursor gas and injected into the reaction gas; and the flow rate of vector gas coming from an external source of vector gas and injected into the reaction gas;
· in such a manner as to obtain a desired fraction of pyrolytic carbon precursor gas in the reaction gas admitted into the oven.

2. A method according to claim 1, **characterized in that** the hydrogen contained in the gas stream extracted from the effluent gas, and a flow rate of hydrogen as separated out in this way and recycled in the reaction gas is controlled in such a manner as to obtain a desired hydrogen content in the reaction gas admitted into the oven.

3. A method according to claim 1, **characterized by**:
· measuring the quantities of pyrolytic carbon precursor gas, vector gas, and hydrogen contained in the gas stream extracted from the effluent gas; and
· as a result of the measured quantities, controlling: the flow rate of said gas stream that is recycled in the reaction gas; the flow rate of the reagent gas coming from an external source of pyrolytic carbon precursor reagent gas and injected into the reaction gas; and the flow rate of vector gas coming from an external source of vector gas and injected into the reaction gas;
· in such a manner as to obtain desired fractions of pyrolytic carbon precursor reagent gas, of vector gas, and of hydrogen in the reaction gas admitted into the oven.

4. A method according to claim 2 or claim 3, **characterized in that**, at least during an initial stage of the method, the flow rate of hydrogen coming from an external source of hydrogen and injected into the reaction gas is also controlled.

5. A method according to any one of claims 1 to 4, **characterized in that** the respective quantities of a plurality of hydrocarbon gases contained in the gas stream extracted from the effluent gas are measured and an equivalent content of pyrolytic carbon precursor gas is determined by weighting the measured quantities as a function of the number x of carbon atoms in said hydrocarbon gases.

6. A method according to claim 5, **characterized in that** account is taken of those CₓH_{y} hydrocarbon gases for which 1 < x < 6.

7. A method according to any one of claims 1 to 6, **characterized in that** the vector gas is constituted at least in part by methane.

8. A method according to any one of claims 1 to 7, **characterized in that** the vector gas is constituted at least in part by an inert gas selected from nitrogen, argon, helium, or a mixture of two or more thereof.

9. A method according to any one of claims 1 to 8, **characterized in that** the effluent gas removed from the oven is treated prior to extracting the gas stream for recycling, so as to eliminate heavy hydrocarbons comprising in particular polycyclic aromatic hydrocarbons.

10. A method according to claim 9, **characterized in that** polycyclic aromatic hydrocarbons are eliminated by washing by injecting aromatic oil into a flow of effluent gas.

11. A method according to claim 9, **characterized in that** heavy hydrocarbons are eliminated at least in part by condensation.

12. A method according to any one of claims 9 to 11, **characterized in that** the treatment of the effluent gas includes eliminating benzene hydrocarbons.
